Europäisches Patentamt

(19) **European Patent Office**

**Office européen des brevets**

(11) Numéro de publication: **0 028 176**
**B1**

(12) **FASCICULE DE BREVET EUROPEEN**

(45) Date de publication du fascicule du brevet: **09.05.84**

(51) Int. Cl.³: **G 01 R 21/00**

(21) Numéro de dépôt: **80401418.1**

(22) Date de dépôt: **06.10.80**

(54) Procédé et dispositif de mesure de puissance électrique.

(30) Priorité: **24.10.79 FR 7926447**

(43) Date de publication de la demande:
**06.05.81 Bulletin 81/18**

(45) Mention de la délivrance du brevet:
**09.05.84 Bulletin 84/19**

(84) Etats contractants désignés:
**BE CH DE LI**

(56) Documents cités:
**DE - A - 2 537 549**
**DE - A - 2 710 712**
**FR - A - 357 907**

(73) Titulaire: **ENERTEC SOCIETE ANONYME**
**12, Place des Etats-Unis**
**F-92120 Montrouge (FR)**

(72) Inventeur: **Lagrave, Jean-Pierre**
**165, rue Aristide Briand**
**F-94230 Cachan (FR)**

(74) Mandataire: **Bentz, Jean-Paul**
**GIERS SCHLUMBERGER Service BREVETS 12,**
**place des Etats-Unis**
**F-92124 Montrouge Cedex (FR)**

Courier Press, Leamington Spa, England.

## 0 028 176

**Description**

La présente invention concerne un procédé et un dispositif de mesure de puissance électrique respectivement conformes aux préambules des revendications 1 et 14.

Le domaine d'application de l'invention est celui de la mesure de puissance, notamment active ou réactive, sur un réseau alternatif en particulier, mais non exclusivement, sur un réseau de distribution d'électricité, par exemple au départ d'un poste de transformation moyenne tension.

Il a déjà été proposé un procédé du type selon lequel on transmet par un canal unique à un organe de calcul des échantillons prélevés à des instants différents et représentatifs des grandeurs électriques différentes du réseau relatives à la ou chaque puissance à mesurer.

Des signaux électriques analogiques représentatifs des grandeurs électriques sont transmis à un dispositif convertisseur analogique-numérique. Pour des raisons d'économie de matériel, il est souhaitable de n'utiliser qu'un seul convertisseur. On est alors conduit à échantillonner successivement les différents signaux des capteurs en interposant un multiplexeur analogique entre ceux-ci et le convertisseur. Les informations numériques obtenues sont transmises à un organe de calcul.

Les échantillons sont prélevés à des instants différents, l'intervalle de temps entre les prélèvements étant au moins égal au temps nécessaire à la conversion d'un échantillon. Si, pour le calcul de la puissance, on forme des produits entre un échantillon de tension et un échantillon d'intensité qui ne représentent pas les valeurs de tension et d'intensité à un même moment, le résultat ainsi obtenu est faux. L'erreur peut être réduite en utilisant un convertisseur très rapide. Ceci conduit toutefois à un matériel coûteux sans pour autant obtenir un résultat exact. Par ailleurs, l'erreur dépend des conditions d'état des grandeurs échantillonnées et ne peut donc être déterminée une fois pour toutes afin de réaliser une correction systématique de la puissance calculée.

Pour remédier à ces inconvénients, il a été proposée, par exemple dans le brevet français FR—A—2357907, de prélever un grand nombre d'échantillons et d'effectuer des opérations au moins virtuelles d'interpolation ou d'extrapolation à partir de plusieurs échantillons d'une même grandeur, par exemple de la tension, pour estimer la valeur de cette grandeur au moment du prélèvement d'une autre grandeur, par exemple l'intensité. Par ce procédé, on dispose ainsi de deux valeurs représentatives, de la tension et de l'intensité à un même instant. L'erreur de calcul peut être minimisée à une valeur acceptable. Toutefois, ceci est obtenu au prix d'une capacité de mémoire élevée et de moyens de calcul particuliers.

La présente invention a pour but de fournir un procédé du type indiqué plus haut pour effectuer un calcul de puissance précis avec un nombre d'échantillons réduit et sans opération supplémentaire d'interpolation ou d'extrapolation.

Ce but est atteint par un procédé tel que défini par la revendication 1 et par un appareil tel que défini par la revendication 14.

En particulier l'invention est notamment basée sur le fait que l'erreur sur une puissance élémentaire commise en multipliant l'un par l'autre un échantillon de tension et un échantillon d'intensité prélevés à des instants différents est sensiblement compensée par l'erreur commise en multipliant l'un par l'autre un autre échantillon de tension et un autre échantillon d'intensité prélevés eux aussi à des instants différents, avec un même intervalle de temps, mais dans l'ordre inverse. Cette compensation n'est pas absolue, mais l'erreur subsistant est non seulement faible mais en plus systématique. Cette erreur peut donc être calculée une fois pour toutes en fonction des conditions de prélèvement des échantillons ou peut être compensée par le facteur d'échelle.

Les groupes d'échantillons sont prélevés régulièrement sur une durée déterminée correspondant à un nombre entier, égal ou supérieur à 1, de demi-périodes du réseau.

Un cycle de prélèvements effectué sur une telle durée suffit pour le calcul de la ou des puissances désirées. Toutefois, ceci n'exclut pas la possibilité d'effectuer plusieurs cycles différents sur des durées identiques ou non, mais toujours égales à ou multiples de la demi-période du réseau. La durée de prélèvement peut être continue, auquel cas les groupes sont prélevés à intervalles de temps réguliers $\Delta T$, ou discontinue, auquel cas le prélèvement des groupes a lieu pendant des durées séparées les unes des autres par une ou plusieurs périodes To du réseau. Dans un cas comme dans l'autre, deux groupes d'échantillons consécutifs sont prélevés avec un intervalle de temps $\Delta T + mTo$, m étant un nombre entier ou nul. Dans la mesure où les grandeurs électriques échantillonnées sont suffisamment stables, le même résultat sera obtenu avec une durée de prélèvement continue ou non.

La répartition des instants de prélèvement des groupes du premier type et la répartition des instants de prélèvement des groupes du second type sont symétriques l'une de l'autre par rapport au milieu de la durée de prélèvement.

Ainsi, il y a autant de groupes du premier type que de groupes du second type et à un groupe d'un type prélevé à un instant donné correspond un groupe de l'autre type prélevé avec une avance ou un retard égal à un nombre entier de quarts de période. La compensation s'effectue alors entre puissances élémentaires calculées à partir d'échantillons prélevés à des instants auxquels les grandeurs électriques échantillonnées ont sensiblement même amplitude, en valeur absolue.

Suivant un premier mode particulier de mise en oeuvre du procédé conforme à l'invention, l'on prélève alternativement un groupe du premier type et un groupe du second type.

2

**0 028 176**

Suivant un autre mode particulier de mise en oeuvre du procédé conforme à l'invention, l'on prélève successivement tous les groupes du premier type puis tous les groupes du second type.

De préférence, chaque groupe d'échantillons comprend un seul échantillon de chaque grandeur électrique nécessaire au calcul de la ou des puissances à mesurer.

Ainsi, dans le cas d'un réseau alternatif triphasé équilibré, chaque groupe d'échantillons peut n'être constitué que par un échantillon d'intensité de courant entre un échantillon de tension simple et un échantillon de tension composée ou inversement pour la mesure des puissances active et réactive.

Selon un autre mode de réalisation du procédé conforme à l'invention, dans le cas d'un réseau monophasé ou triphasé équilibré, il est possible de calculer la puissance active et la puissance réactive en ne prélevant que des groupes comportant simplement un couple d'échantillons tension-intensité. A cet effet, on prélève au moins un ensemble d'échantillons constitués de 2 k groupes prélevés successivement et réguliérement sur une demi-période du réseau et comportant chacun un couple d'échantillons de tension et d'intensité, k étant un nombre entier; on calcule celle parmi les puissances active et réactive correspondant à la nature des grandeurs échantillonnées à partir du cumul des produits deux à deux des échantillons de chaque groupe; et l'on calcule l'autre puissance à partir du cumul des produits deux à deux de l'échantillon d'intensité—ou de tension—d'un groupe avec l'échantillon de tension—ou d'intensité—du $k^{\text{ème}}$ groupe compté à partir de ce groupe. Puisque le prélèvement des 2 k groupes est effectué réguliérement sur une demi-période, l'écart en temps entre les prélèvements d'un groupe et du $k^{\text{ème}}$ groupe compté à partir de celui-ci est égal à un quart de période. On utilise donc la propriété bien connue selon laquelle les tensions servant au calcul des puissances active et réactive sont en quadrature dans le cas d'un réseau équilibré.

Dans le cas d'un réseau alternatif polyphasé non nécessairement équilibré, chaque groupe d'échantillons peut comporter, pour chaque phase, un sous-groupe comprenant un échantillon d'intensité de courant de phase et au moins un échantillon de tension, dans cet ordre ou dans l'autre, pour le calcul de la puissance active et/ou réactive. Dans les groupes du premier type, l'ordre des phases est invariable et inverse de celui dans les groupes du second type.

Selon un autre mode de réalisation du procédé conforme à l'invention dans le cas d'un réseau triphasé non nécessairement équilibré, on peut calculer la puissance active et/ou la puissance réactive par la méthode dite des deux ponts. A cet effet, chaque groupe d'échantillons comporte au moins deux couples d'échantillons formé chacun d'un échantillon de tension et d'un échantillon d'intensité représentatif de la différence entre les les intensités de courants de deux phases du réseau. On peut utiliser un capteur fournissant directement un signal représentatif d'une différence entre deux intensités et le nombre de grandeurs à échantillonner est donc réduit par rapport au cas général envisagé dans le paragraphe précédent.

Lorsque des harmoniques sont présents dans les grandeurs électriques échantillonnées, il est préférable que l'effet de compensation décrit ci-avant pour le fondamental joue également pour les harmoniques des premiers rangs.

Ainsi, selon un mode particulier du procédé conforme à l'invention, l'on prélève réguliérement 16 groupes d'échantillons pendant une période du réseau, soit alternativement un groupe du premier type et un groupe du second type, soit huit groupes du premier type suivis de huit groupes du second type. La compensation est alors obtenue pour les harmoniques pairs et pour les harmoniques de rang impair jusqu'à l'harmonique 7.

La fréquence de prélèvement, des groupes d'échantillons est multiple de la fréquence nominale du réseau.

On peut élaborer cette fréquence de prélèvement à partir de la fréquence réelle du réseau pour s'affranchir de possibles variations de la fréquence du réseau.

Sinon, dans le cas où la fréquence de prélèvement des groupes est fixée selon une autre particularité du procédé conforme à l'invention, l'on détecte le passage de l'une choisie des grandeurs électriques échantillonnées dans un premier état déterminé, l'on déclenche le prélèvement régulier de groupes d'échantillons en réponse à cette détection, l'on détecte le passage de cette même grandeur électrique dans un second état en opposition de phase avec le premier, et l'on déclenche le prélèvement régulier d'un même nombre de groupes d'échantillons en réponse à cette seconde détection. On gerantit ainsi le prélèvement d'une moitié exactement des groupes d'échantillons sur chaque demipériode réelle même si la fréquence du réseau varie, tout en restant toutefois dans certaines limites.

Enfin, selon encore un autre mode de réalisation du procédé conforme à l'invention, on calcule la valeur moyenne des échantillons d'une grandeur électrique prélevés sur une durée égale à ou multiple de la période du réseau, pour fournir une référence de zéro pour les échantillons de cette grandeur. La valeur moyenne de la grandeur étant nulle sur une ou plusieurs périodes, on dispose ainsi directement d'une référence de zéro sans faire appel à une référence extérieure.

L'appareil de mesure de puissance électrique defini dans la revendication 14 comporte une mémoire pour enregistrer les échantillons prélevés pendant la durée de prélèvement et convertis par le convertisseur.

Le nombre d'échantillons nécessaires au calcul de la puissance étant relativement faible, la mémoire n'a pas à avoir une grande capacité.

Les particularités du procédé et de l'appareil conformes à l'invention ressortiront à la lecture de la

3

**0 028 176**

description faite ci-après, à titre indicatif mais non limitatif, en référence aux dessins joints sur lesquels:

— la figure 1 est un schéma général d'un mode de réalisation d'un appareil de mesure conforme à l'invention;
— la figure 2 illustre les formes d'ondes d'une intensité et d'une tension et les instants de prélèvement des échantillons de ces grandeurs conformément à l'invention;
— la figure 3 est un organigramme montrant la mesure notamment des puissances active et réactive à partir de couples d'échantillons d'une intensité et d'une tension seulement, et,
— la figure 4 est une variante de réalisation de l'appareil illustré par la figure 1 pour la mesure de puissance sur un réseau triphasé non nécessairement équilibré.

Dans ce qui suit, on considérera que les prélèvements d'échantillons de grandeurs électriques nécessaire au calcul de la ou des puissances recherchées sont effectués sur une durée continue égale à une période du réseau, soit une durée de 20 ms dans le cas d'un réseau de fréquence nominale égale à 50 Hz. Comme déjà indiqué, la durée de prélèvement peut être continue ou discontinue et peut être différente d'une période tout en restant toutefois un multiple entier de la demi-période du réseau.

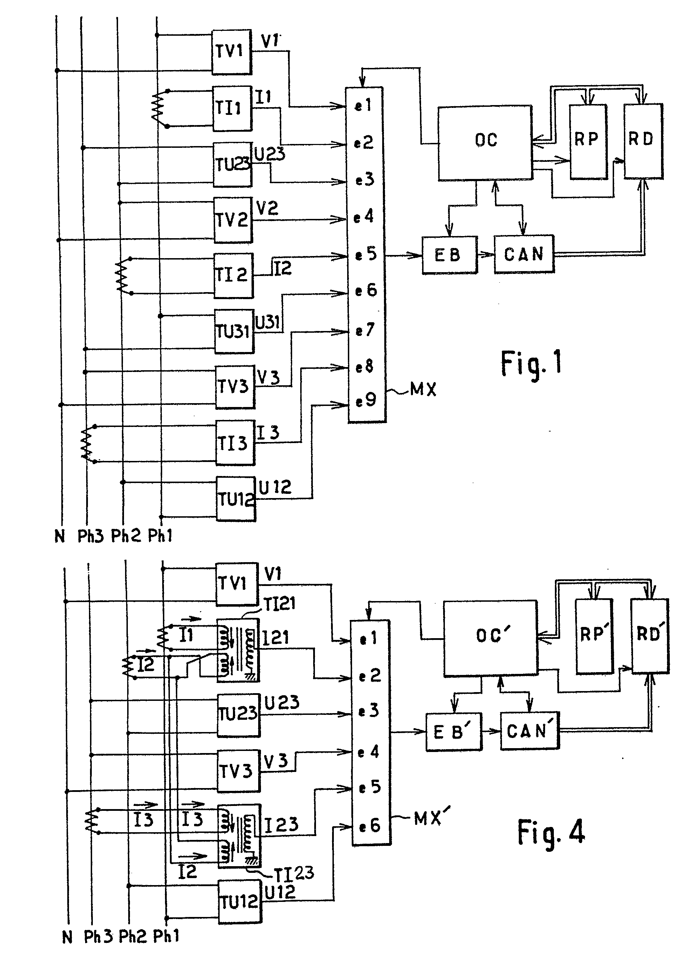

Si l'on considère par exemple le cas de la mesure de puissance active et réactive sur un réseau triphasé, l'invention peut être mise en oeuvre au moyen d'un appareil dont le schéma général est représenté sur la figure 1.

Des capteurs de tension, par exemple des transformateurs TV1, TV2, TV3, délivrent des signaux V1, V2, V3 dont les amplitudes représentent les tensions simples et des transformateurs TU23, TU31, TU12 délivrent des signaux U23, U31, U12 dont les amplitudes représentent les tensions composées (tensions entre phases).

Des capteurs d'intensité, par exemple des transformateurs d'intensité TI1, TI2, TI3 délivrent des signaux I1, I2, I3 dont les amplitudes représentent les courants de phase.

Les signaux des différents capteurs sont appliqués aux entrées d'un multiplexeur analogique MX dont la sortie est reliée par une liaison unique à l'entrée d'un convertisseur analogique-numérique CAN par l'intermédiaire d'un échantillonneur-bloqueur EB.

La sortie du convertisseur CAN est reliée à un dispositif de traitement numérique d'informations comportant des mémoires RP et RD de programmes et de données et un organe de calcul OC de type microprocesseur. Les informations numériques fournies par le convertisseur CAN sont enregistrées dans les mémoires de données RD sous la commande du microprocesseur. Celui-ci exécute les instructions des microprogrammes contenus dans la mémoire RP pour d'une part, commander le multiplexeur MX et l'échantillonneur-bloqueur EB et, d'autre part, effectuer les opérations nécessaires sur les informations numériques reçues.

Dans le cas de la figure 1, les entrées e1 à e9 du multiplexeur MX reçoivent respectivement les signaux V1, I1, U23, V2, I2, U31, V3, I3, U12. Dans le cas d'un réseau triphasé non nécessairement équilibré, des échantillons de chacun de ces signaux peuvent être prélevés pour calculer la puissance active P et la puissance réactive Q ainsi que les grandeurs de chacune des phases. Le multiplexeur MX commandé par l'organe de calcul OC connecte le convertisseur CAN aux capteurs pour prélever des groupes d'échantillons comportant un échantillon de chacun des signaux appliqués aux entrées e1 à e9 dans cet ordre, ainsi que des groupes d'échantillons comportant un échantillon de chacun des signaux appliqués aux entrées e9 à e1, c'est-à-dire dans l'ordre inverse par rapport aux autres groupes. Ainsi, on forme des groupes d'échantillons d'un premier type G1 constitués comme suit:

$$V1^* \; I1^* \; U23^* \; V2^* \; I2^* \; U31^* \; V3^* \; I3^* \; U12^*$$

(l'astérique indiquant qu'il s'agit d'un échantillon de la grandeur désignée par cet astérisque), et l'on forme des groupes d'échantillons d'un second type G2 constituées comme suit:

$$U12^* \; I3^* \; V3^* \; U31^* \; I2^* \; V2^* \; U23^* \; I1^* \; V1^*$$

On notera que, pour chaque phase, dans chaque groupe, l'intensitée du courant de phase est prélevée entre la tension simple et la tension composée correspondante (ou inversement). On notera en outre que l'ordre des phases est invariable dans les groupes du premier type et est l'inverse de celui des groupes du second type.

Tous les échantillons sont prélevés à des instants différents. Il n'y a donc pas dans les groupes d'échantillons formés, deux échantillons d'une même grandeur ou de deux grandeurs différentes prélevés à un même instant.

Les moments de prélèvement des groupes du premier type—c'est-à-dire les instants où les premiers échantillons de ces groupes sont prélevés—ont une répartition sur la durée de prélèvement sensiblement symétrique de celle des moments de prélèvement des groupes du second type par rapport au milieu de la durée de prélèvement.

Supposons que le nombre de groupes d'échantillons prélevés sur une période To est égale à 12. A titre d'exemple, les groupes G1 et G2 pourront être prélevés selon l'une des combinaisons suivantes:

4

```
G1   G2   G1   G2   G1   G2   G1   G2   G1   G2   G1   G2,
G1   G1   G1   G1   G1   G1   G2   G2   G2   G2   G2   G2,
G1   G1   G2   G2   G1   G1   G2   G2   G1   G1   G2   G2,   ou
G1   G1   G1   G2   G2   G2   G1   G1   G1   G2   G2   G2.
```

Le séquences usuelles seront celles au cours desquelles l'ordre de prélèvement des échantillons est inversé pour chaque nouveau groupe prélevé (alternativement G1 et G2), ou celles au cours desquelles on prélève successivement tous les groupes d'un même type puis tous les groupes de l'autre type.

Deux échantillons d'une groupe d'une type, représentant deux grandeurs à multiplier l'une par l'autre pour le calcul d'une puissance sont prélevés avec un intervalle de temps $\Delta t$ égal à celui séparant les instants de prélèvement des échantillons des deux mêmes grandeurs dans un groupe de l'autre type.

Ainsi, on peut compenser sensiblement, par l'inversion de l'ordre de prélèvement des échantillons l'erreur provenant du fait que les deux grandeurs relatives à une même puissance sont prélevées à des instants différents.

Plus précisément, l'inversion de l'ordre des échantillons permet de minimiser l'erreur résultant du déphasage des échantillons, cette dernière étant systématique et donc rattrapable, du fait que les groupes d'échantillons sont prélevés de façon régulièrement répartie sur la durée du prélèvement. Le rattrapage de l'erreur peut être réalisé en affectant les grandeurs échantillonnées d'un coefficient multiplicateur correcteur.

Avantageusement, la cadence de prélèvement des échantillons dans chaque groupe est constante et aussi élevée que possible compte-tenu des performances du convertisseur. A titre d'exemple, l'intervalle de temps séparant les prélèvements de deux échantillons consécutifs d'un même groupe est égal à 100 $\mu s$, ceci pour chaque groupe.

Le nombre de groupes d'échantillons prélevés sur une période est limité par le temps de prélèvement de chaque échantillon. Ainsi, si la fréquence nominale des grandeurs échantillonnées est égale à 50 Hz, on ne pourra pas prélever plus de 22 groupes de neuf échantillons.

Par ailleurs, le nombre de groupes d'échantillons doit permettre de prendre en compte les harmoniques éventuels de manière à réaliser la compensation par l'inversion de l'ordre des prélèvements non seulement pour le fondamental, mais aussi au moins pour les harmoniques des premiers rangs. Il s'avère que ce résultat est obtenu avec huit groupes d'échantillons, pour tous les harmoniques de rang pair et pour ceux de rang impair jusqu'à cinq et, avec 16 groupes d'échantillons, pour tous les harmoniques de rang pair et pour ceux de rang impair jusqu'à sept.

Ainsi, suivant un mode préféré de mise en oeuvre de l'invention, 16 groupes d'échantillons sont prélevés sur la période To des grandeurs échantillon nées, ou un multiple entier de 16, dans la mesure où cela est possible.

Les différents groupes sont prélevés régulièrement sur la période To avec une fréquence

$$\frac{N}{To}$$

N étant le nombre total de groupes prélevés.

Dans le cas où la fréquence des grandeurs échantillonnées ne varie sensiblement pas, par exemple dans le cas de tensions et intensités d'un réseau de distribution d'électricité, la fréquence

$$\frac{N}{To}$$

peut être prédéterminée indépendamment de celle du réseau. Il faut toutefois pouvoir tenir compte de possibles variations de la fréquence de réseau afin d'éviter une inégale répartition des échantillons prélevés sur les deux demi-périodes.

Ainsi, avantageusement, l'on détecte le passage d'une grandeur quelconque prédéterminée des grandeurs échantillonnées dans un état déterminé pour déclencher au moyen du multiplexeur MX le prélèvement de

$$\frac{N}{2}$$

groupes d'échantillons à la fréquence

$$\frac{N}{To}$$

et l'on détecte le passage de la même grandeur prédéterminée en opposition de phase par rapport audit êtat déterminé pour déclencher le prélèvement des

$$\frac{N}{2}$$

autres groupes à la fréquence

$$\frac{N}{To}$$

Par commodité, on détecte le passage de la grandeur prédéterminée à un maximum ou, de préférence au zéro. Cette détection peut être faite en surveillant au moyen du microprocesseur les valeurs successives de la grandeur prédéterminée fournies par le convertisseur.

Dans le cas du prélèvement de 16 groupes d'échantillons de grandeurs de fréquence nominale égale à 50 Hz, et avec un intervalle de temps de 100 $\mu$S entre deux échantillons du même groupe, huit groupes sont prélevés à la fréquence de 800 Hz à partir d'un passage à zéro de V1 et huit autres groupes sont prélevés à la fréquence de 800 Hz à partir du passage à zéro suivant de V1.

Lorsqu'il y a neuf échantillons par groupe, le prélèvement du huitième groupe est terminé au bout de 9,65 ms. La compensation des variations de fréquence ne joue pas au-delà 51,8 Hz. Quand, comme on le verra plus loin, le nombre d'échantillons par groupe est réduit à trois ou à deux, la compensation n'est pas valable au-delà de 55,2 Hz ou 55,8 Hz.

Par ailleurs, l'irrégularité de la répartition des instants de prélèvement des groupes sur la période des grandeurs échantillonnées est source d'une erreur non rattrapable de façon systèmatique. Ainsi, plus la fréquence réelle décroît ou croît plus importante est l'erreur commise en prélèvant les groupes d'échantillons en deux ensembles de

$$\frac{N}{2}$$

groupes à la fréquence

$$\frac{N}{To}.$$

Cette erreur est toutefois limitée et des variations relatives de fréquence de l'ordre de 10% sont tolérables, pour autant, bien entendu, que les limites supérieures indiquées au paragraphe précédent ne soient pas dépassées.

On a envisagé, ci-avant, le cas général de la mesure des puissances active et réactive sur un réseau triphasé en utilisant des échantillons de neuf grandeurs. Kp et Kq étant des constantes, les valeurs des puissances active P et réactive Q sont:

(1)
$$P=K_p \sum_{i=1}^{N} V1^{\pm}_i \cdot I1^{\pm}_i + V2^{\pm}_i \cdot I2^{\pm}_i + V3^{\pm}_i \cdot I3^{\pm}_i, \text{ et}$$

(2)
$$Q=K_q \sum_{i=1}^{N} U23^{\pm}_i \cdot I1^{\pm}_i + U31^{\pm}_i \cdot I2^{\pm}_i + U12^{\pm}_i \cdot I3^{\pm}_i,$$

c'est-à-dire le cumul pour les N groupes des puissances élémentaires active $p_i$ et $q_i$ obtenues à partir des échantillons de chaque groupe.

Si les trois phases du réseau triphasé sont équilibrées, on peut se contenter pour le calcul des puissances active et réactive, de prélever les échantillons des tensions simple et composée et de l'intensité du courant relatives à une seule phase, par exemple Ph1. Dans ce cas, chaque groupe comporte les échantillons $V1^{\pm}_i$ $I1^{\pm}_i$ $U23^{\pm}_i$ dans cet ordre, ou dans l'ordre inverse, l'intensité étant prélevée entre les tensions.

On a alors:

(3)
$$P=3 K_p \sum_{i=1}^{N} V1^{\pm}_i \cdot I1^{\pm}_i \text{ et}$$

(4)
$$Q = 3\,K_q \sum_{i=1}^{N} U23_i^{\pm} \cdot I1_i^{\pm}$$

On sait que les tensions utilisées pour le calcul des puissances active et réactive sur une même phase ont des amplitudes proportionnelles et sont en quadrature dans le cas d'un réseau triphasé équilibré. Si le nombre N de groupes d'échantillons régulièrement prélevés sur une période est un multiple de quatre (N=4 k), on peut alors écrire ($K_p'$ et $K_q'$ étant des constantes):

(5)
$$P = K_p' \sum_{i=1}^{N} V1_i^{\pm} \cdot I1_i^{\pm}, \text{ et}$$

(6)
$$Q = K_q' \sum_{i=1}^{N} V1_j^{\pm} \cdot I1_i^{\pm}$$

avec

$$j = i+k \text{ si } 1 \leqslant i \leqslant N-k$$
$$j = (i+k)-N \text{ si } N-k < i \leqslant N.$$

En effet, un quart de période sépare l'échantillon de tension d'un groupe de celui du $k^{ème}$ groupe compté à partir de celui-ci, et ces deux échantillons de tension sont bien en quadrature.

Cette méthode permet donc le calcul de la puissance active et de la puissance réactive à partir de groupes formés d'un seul couple d'échantillons tension-intensité dans le cas du triphasé équilibré ou du monophasé.

Selon une particularité avantageuse de l'invention, une valeur de référence de zéro est élaborée à partir des échantillons prélevés.

Dans la mesure où les groupes d'échantillons sont prélevés régulièrement sur une période, les valeurs moyennes des échantillons de chaque grandeur sont nulles. Le calcul des valeurs moyennes des grandeurs fournit donc une référence de zéro pour celle-ci.

Ainsi, dans le cas par exemple du calcul effectué par les formules (5) et (6) ci-dessus, si

$$M_v = \frac{1}{N} \sum_{i=1}^{N} V1_i^{\pm} \text{ et } M_I = \frac{1}{N} \sum_{i=1}^{N} I1_j^{\pm}$$

les puissances active et réactive corrigées P' et Q' sont

$$P' = K_p' \sum_{i=1}^{N} (V1_i^{\pm} - M_v) \cdot (I1_i^{\pm} - M_I)$$

$$Q' = K_q' \sum_{i=1}^{N} (V1_j^{\pm} - M_v) \cdot (I1_i^{\pm} - M_I), \text{ soit}$$

(7)
$$P' = K_p' \sum_{i=1}^{N} V1_i^{\pm} \cdot I1_i^{\pm} - N \cdot M_v \cdot M_I$$

(8)
$$Q' = K_q' \sum_{i=1}^{N} V1_j^{\pm} \cdot I1_i^{\pm} - N \cdot M_v \cdot M_I$$

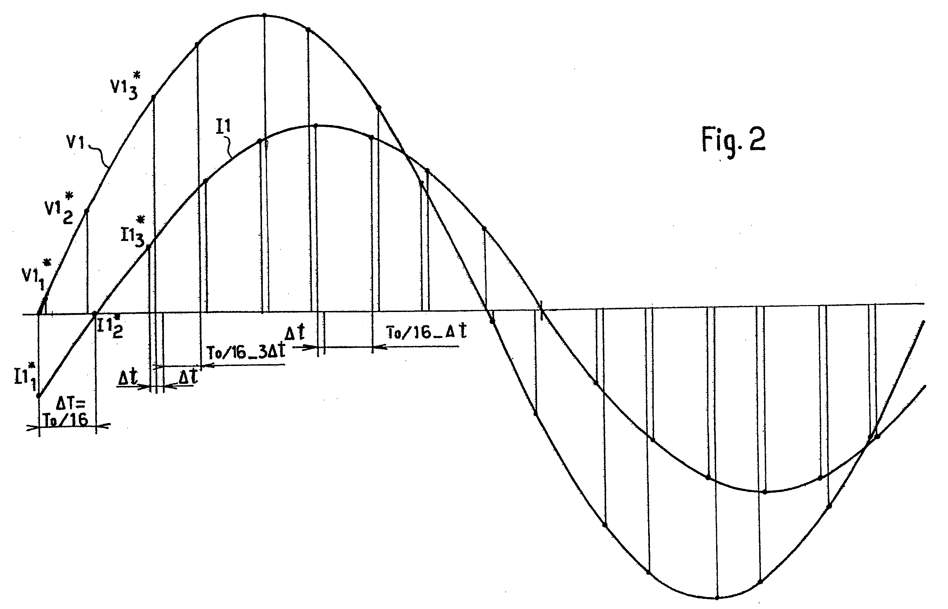

La figure 2 illustre le prélèvement sur une période, de 16 groupes d'échantillons d'une tension V1 et d'un courant I1 de fréquence 50 Hz avec déclenchement du prélèvement de huit groupes à chaque passage à zéro de V. Chaque groupe est formé de deux échantillons prélevées chacun avec un intervalle de temps $\Delta t$ de 100 $\mu s$. Les échantillons d'intensité sont prélevés à une cadence d'un échantillon d'intensité toutes les 1250 $\mu s$. L'ordre de prélèvement est inversé pour chaque nouveau groupe prélevé.

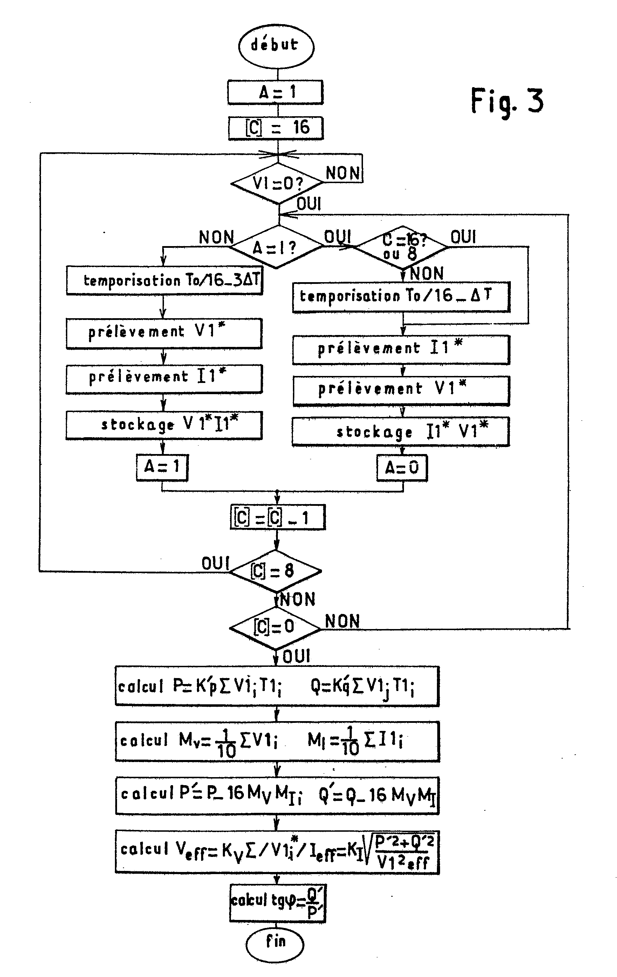

La figure 3 illustre un organigramme du fonctionnement de l'organe de calcul OC pour déterminer las puissances P' et Q' selon les formules (7) et (8). Le multiplexeur MX ne reçoit que les signaux représentatifs, d'une tension de phase et de l'intensité du courant de la même phase, par exemple V1 et I1 comme illustré par la fig. 2. On notera que deux capteurs seulement sont alors nécessaires.

Un index A est placé à 1 et un compteur C est placé à la valeur N=16 en phase d'initialisation.

A un premier passage à zéro de V1, on vérifie que l'index A est à 1 et immédiatement on prélève successivement un premier échantillon $I1^{\pm}$ de $I1$ et un premier échantillon $V1^{\pm}$ de V1. On mémorise ces échantillons et l'index A est mis à zéro. Le contenu du compteur C est décrémenté puis comparé successivement à l'état 8 et à 0.

L'index A est examiné et, à la fin d'une temporisation

$$\frac{To}{16} - 3 \cdot \Delta t$$

comptée à partir de la fin du prélèvement de $V1^{\pm}_1$, l'on prélève et l'on mémorise un second échantillon de tension $V1^{\pm}_2$ puis un second échantillon de courant $I1^{\pm}_2$. On place l'index A à 1, l'on décrémente le compteur C et l'on examine son contenu. On examine l'index A; le contenu du compteur C étant différent de 16 et 8, à la fin d'une temporisation

$$\frac{To}{16} - \Delta t$$

comptée à partir de la fin du prélèvement de $I1^{\pm}_2$, l'on effectue un nouveau prélèvement d'un couple d'échantillons de courant $I1^{\pm}_3$—échantillon de tension $V1^{\pm}_3$ que l'on mémorise.

On procède ainsi jusqu'à ce que le contenu du compteur C soit égal à huit.

On revient alors en attente du nouveau passage à zéro de V1 pour prélever et mémoriser les huit groupes d'échantillons restants.

Lorsque le compteur C passe à zéro, le prélèvement est terminé et tous les échantillons sont stockés dans RD. Les 32 échantillons mémorisés sont alors utilisés pour calculer

$$P = K'_p \sum_{i=1}^{16} V1^{\pm}_i I1^{\pm}_i$$

$$Q = K'_q \sum_{i=1}^{16} V1^{\pm}_j I1^{\pm}_i$$

$$j = i+4 \text{ si } 1 \leqslant i \leqslant 16-4$$
$$j = i+4-16 \text{ si } 16-4 < i \leqslant 16$$

$$M_v = \frac{1}{16} \sum_{i=1}^{16} V1^{\pm}_i$$

$$M_I = \frac{1}{16} \sum_{i=1}^{16} I1^{\pm}_i$$

$$P' = P - 16\,M_v M_I$$
$$Q' = Q - 16\,M_v M_I$$

En plus des valeurs de puissances active et réactive, peuvent également être calculées les valeurs efficaces de V1 et I1, respectivement:

$$V1_{eff} = K_v \sum_{i=1}^{16} |V1^{\pm}_i|, K_v$$

étant le rapport entre la valeur efficace et la valeur moyenne des valeurs absolues des échantillons de tension (correspondant au redressement de celle-ci), quand le prélèvement des échantillons est déclenché au passage à zéro de V1 et

$$I1_{eff} = K_I \sqrt{\frac{P'^2 + Q'^2}{V1^2_{eff}}}$$

ou

8

$$I1_{eff} = K'_1 \sqrt{\sum_{i=1}^{16} I1_i^2}$$

avec

$$I1_i = I1_i^{\pm} - \frac{MI}{16}$$

Les coefficients $K_1$ et $K'_1$ sont des constantes.

Enfin, on peut également calculer

$$tg \varphi = \frac{Q'}{P'}$$

Le coefficient $K_v$ dépend du nombre et des moments de prélèvements des échantillons de tension et peut dont être prédéterminé.

Les coefficients $K'_p$ et $K'_q$ sont déterminés en fonction du rapport de transformation des capteurs et du convertisseur utilisés et aussi compte-tenu de la correction d'erreur systématique à apporter. A titre indicatif, dans le cas envisagé ci-dessu en référence aux figures 2 et 3, l'erreur relative sur la puissance élémentaire calculée en multipliant l'un par l'autre deux échantillons d'un même groupe est:

$$1 - \cos 2\pi \times 50 \times 10^{-4}$$

soit environ $5.10^{-4}$

Le procédé et l'appareil conformes à l'invention peuvent aussi être utilisés pour surveiller plusieurs réseaux monophasés ou triphasés en sortie d'un poste de transformation moyenne tension. Dans ce cas, on peut effecteur les opérations décrites ci-dessus cycliquement pour les différents réseaux.

La phase de l'initialisation de l'organigramme comprend alors la détermination parmi un ensemble de valeurs stockées, des coefficients $K'_p$ et $K'_q$ propres au réseau examiné ainsi que la détermination de la grandeur dont le passage à zéro est à détecter.

Une modification de l'appareil conforme à l'invention est illustrée par la figure 4 dans le cas de la mesure de puissance réactive sur un réseau tri-phasé non nécessairement équilibré.

Un capteur TI21 comporte deux enroulements primaires parcourus par des courants représentatifs des courants I1 et I2 des phases Ph1 et Ph2 et disposés en opposition. Aux bornes de l'enroulement secondaire, on recueille un signal I21 proportionnel à la différence I1—I2. Un capteur analogue TI23 délivre un signal I23 représentatif de la différence I3—I2. Les signaux I21 et I23 sont appliqués aux entrées $e_2$ et $e_5$ d'un multiplexeur MX'. Les signaux V1, V3, U23, U12 représentatifs des tensions des phases Ph1, Ph3 et des tensions entre phases Ph3—Ph2 et Ph2—Ph1 sont fournis par des capteurs TV1, TV3, TU23 et TU12 et sont appliqués aux entrées $e_1$, $e_4$, $e_3$, $e_6$ du multiplexeur MX'. Comme précédemment, la sortie du multiplexeur MX' est reliée par une liaison unique à un convertisseur analogique-numérique CAN' par l'intermédiaire d'un échantillonneur-bloquer EB'. Les informations numériques transmises par le convertisseur CAN' sont traitées au moyen d'un organe de calcul OC' associé à des mémoires de programmes RP' et de données RD' et commandant le multiplexeur MX' et l'échantillonneur-bloqueur EB'.

On sait que les puissances active et réactive P″ et Q″ du réseau triphasé peuvent être exprimées par

$$P'' = V1\,(I1-I2) + V3(I3-I2)\ et$$

$$Q'' = \frac{1}{\sqrt{3}}[U23\,(I1-I2) + U12(I3-I2)]$$

L'organe de calcul OC' détermine alors des prélèvements de groupes successifs comportant chacun les échantillons

$$V1^{\pm},\ (I1-I2)^{\pm},\ U23^{\pm},\ V3^{\pm},\ (I3-I2)^{\pm},\ U12^{\pm}$$

dans cet ordre ou dans l'ordre inverse.

La cadence de prélèvement des groupes, la répartition des groupes selon l'ordre de prélèvement

9

des échantillons, la fréquence de prélèvement des échantillons dans chaque groupe, le nombre de groupes et le déclenchement des prélèvements des groupes en deux ensembles sont tels que décrits ci-avant.

Pour le calcul de puissances actives P″ et réactive Q″, on effectue:

$$P''=K_p'' \sum_{i=1}^{N} V1_i^{\pm}(I1-I2)_i^{\pm}+V3_i^{\pm}(I3-I2)_i^{\pm},$$

$$Q''=K_q'' \sum_{i=1}^{N} U23_i^{\pm}(I1-I2)_i^{\pm}+U12_i^{\pm}(I3-I2)_i^{\pm},$$

N étant le nombre de groupes et $K_p''$ et $K_q''$ deux constantes.

On a envisagé en détail (figure 3) le cas où l'appareil conforme à l'invention fonctionne avec prélèvement de groupes de deux échantillons en changeant l'ordre des échantillons dans chaque nouveau groupe prélevé.

Toutefois, le multiplexeur MX (ou MX′) peut être commandé par l'organe de calcul OC (ou OC′) de manière à connecter le convertisseur CAN (ou CAN′) aux différents capteurs pour prélever les groupes du premier type et les groupes du second type avec toute autre répartition convenable dans le temps, notamment avec une répartition des instants de prélèvement des groupes du premier type symétrique, par rapport au milieu de la durée de prélèvement de la répartition des instants, du prélèvement des groupes du second type. Par exemple, au prix d'une modification du microprogramme correspondant, le convertisseur peut être connecté aux capteurs par le multiplexeur de manière à ne changer l'ordre de prélèvement des échantillons dans les groupes que lorsque la moitié des groupes a été prélevée.

## Revendications

1. Procédé de mesure de puissance électrique sur un réseau alternatif procédé selon lequel on transmet par un canal unique à un organe de calcul des échantillons prélevés à des instants différents et représentatifs des grandeurs électriques différentes du réseau relatives à la puissance ou à chaque puissance à mesurer, caractérisé

— en ce qu'on prélève respectivement sur une durée déterminée égale à ou multiple de la demi-période du réseau, des groupes d'échantillons constitués de groupes d'un premier type comportant chacun au moins un couple formé d'échantillons de tension et d'intensité relatifs à une puissance désirée et prélevés dans un ordre déterminé et avec un intervalle de temps déterminé, et des groupes d'un second type en nombre egal à celui des groupes du premier type et comportant chacun au moins un couple d'échantillons de la même tension et de la même intensité que lesdits couples des groupes du premier type, prélevés avec le même intervalle de temps mais dans l'ordre inverse dudit ordre déterminé, tous les groupes des deux types étant constitués d'échantillons tous prélevés à des instants différents les uns des autres, et la répartition des instants de prélèvement des groupes du premier type et la répartition des instants de prélèvement des groupes du second type étant symétriques l'une de l'autre par rapport au milieu de la durée de prélèvement et

— en ce qu'on effectue de cumul des puissances élémentaires obtenues en multipliant deux à deux les échantillons des couples des différents groupes.

2. Procédé selon la revendication 1, caractérisé en ce que l'on prélève alternativement un groupe du premier type et un groupe du second type.

3. Procédé selon la revendication 1, caractérisé en ce que l'on prélève successivement tous les groupes du premier type puis tous les groupes du second type.

4. Procédé selon l'une quelconque des revendications 1 à 3, caractérisé en çe que chaque groupe d'échantillons comprend un seul échantillon de chaque grandeur électrique nécessaire au calcul de la ou des puissances à mesurer.

5. Procédé selon l'une quelconques des revendications 1 à 4, pour la mesure de puissances électriques active et réactive sur un réseau alternatif monophasé ou triphasé équilibré, caractérisé en ce que chaque groupe d'échantillons comporte un échantillon d'intensité de courant entre un échantillon de tension simple et un échantillon de tension composée, ou inversement.

6. Procédé selon l'une quelconque des revendications 1 à 4, pour la mesure de puissances électriques active et réactive sur un réseau alternatif monophasé ou triphasé équilibré, caractérisé en ce que l'on prélève au moins un ensemble d'échantillons constitué de 2 k groupes prélevés successivement et régulièrement sur une demi-période du réseau et comportant chacun un couple d'échantillons de tension et d'intensité, k étant un nombre entier; l'on calcule celle parmi les puissances active et réactive correspondant à la nature des grandeurs échantillonnées à partir du cumul des produits deux à deux des échantillons de chaque groupe; et l'on calcule l'autre puissance à partir du cumul des produits

10

deux à deux de l'échantillon d'intensité—ou de tension—d'un groupe avec l'echantillon de tension—ou d'intensité—du k$^{\text{ème}}$ groupe compté à partir de ce groupe.

7. Procédé selon l'une quelconque des revendications 1 à 4, pour la mesure des puissances électriques sur un réseau alternatif polyphasé, caractérisé en ce que chaque groupe d'échantillons comporte, pour chaque phase, un sous-groupe comprenant un échantillon d'intensité de courant de phase et au moins un échantillon de tension, dans cet ordre ou dans l'autre; l'ordre les phases dans les groupes du premier type étant invariable et inverse de l'ordre des phases dans les groupes du second type.

8. Procédé selon l'une quelconque des revendications 1 à 4, pour la mesure de puissances électriques active et réactive sur un réseau alternatif triphasé, caractérisé en ce que l'on prélève des groupes comportant au moins deux couples d'échantillons formé chacun d'un échantillon de tension et d'un échantillon d'intensité représentatif de la différence entre les intensités de courants de deux phases du réseau.

9. Procédé selon l'une quelconque des revendications précédentes, caractérisé en ce que l'on prélève régulièrement 16 groupes d'échantillons pendant une période du réseau.

10. Procédé selon l'une quelconque des revendications précédentes, caractérisé en ce que l'on détecte le passage de l'une choisie des grandeurs électriques échantillonnées dans un premier état déterminé, l'on déclenche le prélèvement régulier de groupes d'échantillons en réponse à cette détection, l'on détecte le passage de cette même grandeur électrique dans un second état en opposition de phase avec le premier, et l'on déclenche le prélèvement régulier d'un même nombre de groupes d'échantillons en réponse à cette seconde détection.

11. Procédé selon la revendication 10, caractérisé en ce que l'on détecte le passage à zéro de ladite grandeur choisi successivement dans un sens et dans l'autre sens.

12. Procédé selon l'une quelconque des revendications précédentes, caractérisé en ce que l'on calcule la valeur moyenne des échantillons d'une grandeur électrique prélevés sur une durée égale à ou multiple de la période du réseau, pour fournir une référence de zéro pour les échantillons de cette grandeur.

13. Procédé selon l'une quelconque des revendications 1 à 12, caractérisé en ce que l'on prélève régulièrement des groupes d'échantillons sur une durée égale à ou multiple de la période du réseau, chaque groupe comportant au moins un couple d'échantillons de tension et d'intensité, on calcule chaque puissance élémentaire Pi obtenue en multipliant deux à deux les échantillons de chacun desdits couples, on calcule la valeur moyenne M$_V$ des échantillons de tension desdits couples, on calcule la valeur moyenne M$_I$ des échantillons d'intensité desdits couples et on calcule la quantité

$$\sum_{1}^{N} Pi - N \cdot M_V \cdot M_I,$$

N étant le nombre de groupes d'échantillons prélevés et

$$\sum_{1}^{N} Pi$$

étant la somme des N puissances élémentaires calculées.

14. Appareil de mesure de puissance électrique sur un réseau alternatif, comportant un dispositif numérique de calcul de puissance (OC; OC'), un dispositif convertisseur (CAN; CAN') fournissant au dispositif de calcul par un canal unique des informations numériques correspondant à des échantillons prélevés à des instants différents et représentatifs des grandeurs électriques du réseau relatives à la puissance ou à chaque puissance à mesurer, un dispositif de commutation (MX; MX') reliant l'entrée du dispositif convertisseur à des capteurs (TV1, Ti1, TU23, TV2, Ti2, TU31, TV3, Ti3, TU12; TV1, TI21, TU23, TV3, TI23, TU12) desdites grandeurs électriques, et une mémoire (RD; RD') pour enregistrer les échantillons, prélevés pendant une durée de prélèvement et convertis par le convertisseur (CAN; CAN'), caractérisé,

— en ce que le dispositif de commutation (MX, MX') connecte le dispositif convertisseur aux capteurs pour prélever régulièrement, sur une durée sensiblement égale à ou multiple de la demi-période du réseau, des groupes d'échantillons constitués de groupes d'un premier type comportant chacun au moins un couple d'échantillons de tension et d'intensité relatifs à une puissance désirée et prélevés dans un ordre déterminé et avec un intervalle de temps déterminé, et des groupes d'un second type en nombre égal à celui des groupes du premier type et comportant chacun au moins un couple d'échantillons de la même tension et de la même intensité que pour lesdits couples des groupes du premier type, prélevés avec le même intervalle de temps mais dans l'ordre inverse audit ordre déterminé, tous les groupes des deux types étant constitués d'échantillons tous prélevés à des instants différents les uns des autres, et les groupes du premier type ayant une répartition dans le temps symétrique de la répartition des instants de prélèvements des groupes du second type par rapport au milieu de la durée de prélèvement, et

— en ce que le dispositif de calcul comporte des moyens pour calculer et cumuler les puissances élémentaires obtenues en multipliant deux à deux les échantillons desdits couples des différents groupes.

15. Appareil selon la revendication 14, caractérisé en ce que le dispositif de commutation (MX) connecte le dispositif convertisseur (CAN) successivement à différents capteurs (TV1, TI1,...) dans un ordre prédéterminé puis aux mêmes capteurs dans l'ordre inverse, et ainsi de suite.

16. Appareil selon l'une quelconque des revendications 14 et 15, caractérisé en ce que le dispositif de commutation (MX) connecte plusieurs fois le dispositif convertisseur (CAN) successivement à différents capteurs (TV1, TI1,...) dans un ordre déterminé pour prélever les groupes du premier type puis un même nombre de fois aux mêmes capteurs dans l'ordre inverse pour prélever les groupes du second type.

17. Appareil selon l'une quelconque des revendications 14 à 16 pour la mesure de puissance active et réactive d'un réseau alternatif triphasé, caractérisé en ce que pour chaque prélèvement d'un groupe d'échantillons pour une ou chaque phase, le dispositif de commutation (MX) connecte le convertisseur (CAN) successivement à un capteur de tension simple (TV1, TV2, TV3) à un capteur d'intensité de courant de phase, (TI1, TI2, TI3) et à un capteur de tension composée (TU23, TU31, TU12) dans cet ordre ou dans l'ordre inverse.

18. Appareil selon l'une quelconque des revendications 14 à 17, pour la mesure de puissances active et réactive d'un réseau alternatif, caractérisé en ce que la mémoire (RD) est destinée à enregistrer un ensemble d'échantillons constitué de 2 k groupes prélevés successivement et régulièrement sur une demi-période du réseau, et comportant chacun un couple d'échantillons de tension et d'intensité, k étant un nombre entier, et le dispositif de calcul (OC) comporte des moyens de calcul et de cumul des puissances élémentaires obtenues en multipliant deux à deux les échantillons de chaque couple et des moyens de calcul et de cumul des puissances élémentaires obtenues en multipliant deux à deux l'échantillon d'intensité ou de tension—d'un groupe avec l'échantillon de tension—ou d'intensité—du $k^{ème}$ groupe compté à partir de ce groupe.

19. Appareil selon l'une quelconque des revendications 14 à 18, pour la mesure de la puissance active et/ou de la puissance réactive d'un réseau alternatif triphasé, caractérisé en ce qu'il comporte au moins deux capteurs d'intensité délivrant chacun un signal (I21, I23) représentatif de la différence entre les intensités des courants de deux phases.

20. Appareil selon l'une quelconque des revendications 14 à 19, caractérisé en ce que la fréquence de prélèvement des groupes d'échantillons est égale à n.16 fois la fréquence du réseau, n étant un nombre entier.

21. Appareil selon l'une quelconque des revendications 14 à 20, caractérisé en ce qu'il comporte des moyens de détection (OC) du passage d'un grandeur choisie parmi lesdites grandeurs électriques dans un état déterminé, pour déclencher le prélèvement d'un nombre déterminé de groupes d'échantillons pendant une durée correspondant à celle d'une demi-période normale du réseau.

22. Appareil selon la revendication 21, caractérisé en ce que lesdits moyens de détection (OC) comportent un dispositif de détection du passage à zéro de la grandeur électrique choisie, dans un sens et dans l'autre.

23. Appareil selon l'une quelconque des revendications 14 à 22, caractérisé en ce que le dispositif de calcul comporte des moyens de calcul de la valeur moyenne des échantillons d'au moins une des grandeurs électriques échantillonnées.

**Patentansprüche**

1. Verfahren zur Messung der elektrischen Leistung an einem Wechselstromnetz, bei welchem über einen einzigen Kanal einem Rechner Abtastproben zugeführt werden, die zu verschiedenen Zeitpunkten abgenommen werden und verschiedene elektrische Größen des Netzes darstellen, welche mit der Leistung bzw. mit jeder zu messenden Leistung zusammenhängen, dadurch gekennzeichnet,

— daß jeweils über eine Dauer, die gleich der halben Netzperiode oder gleich einem Vielfachen derselben ist, Gruppen von Abtastproben abgenommen werden, die zusammengesetzt sind aus Gruppen eines ersten Typs mit jeweils wenigstens einem Paar, welches aus Spannungs und Strom-Abtastwerten gebildet ist, die eine gewünschte Leistung betreffen, wobei diese Abtastwerte in einer bestimmten Reihenfolge und mit einem bestimmten Zeitintervall abgenommen werden, und aus Gruppen eines zweiten Typs, deren Anzahl gleich derjenigen der Gruppen des ersten Typs ist und die jeweils mindestens ein Paar Abtastwerte derselben Spannung und desselben Stroms wie die Paare der Gruppen des ersten Typs enthalten, wobei diese Abtastwerte mit demselben Zeitintervall, jedoch in zu der vorbestimmten Reihenfolge umgekehrter Reihenfolge abgenommen werden, wobei alle Gruppen der beiden Typen aus Abtastproben gebildet sind, die alle zu voneinander verschiedenen Zeitpunkten abgenommen werden, und wobei die Verteilung der Abtastzeitpunkte für die Gruppen des ersten Typs und die Verteilung der Abtastzeitpunkte für die Gruppen des zweiten Typs symmentrisch zueinander in bezug auf die Mitte der Abtastdauer sind, und
— daß die erhaltenen elementaren Leistungen kumuliert werden, indem die Abtastproben der Paare der verschiedenen Gruppe zu zweit multipliziert werden.

2. Verfahren nach Anspruch 1, dadurch gekennzeichnet, daß abwechselnd eine Gruppe des ersten Typs und eine Gruppe des zweiten Typs abgenommen wird.

3. Verfahren nach Anspruch 1, dadurch gekennzeichnet, daß nacheinander alle Gruppen des ersten Typs und anschließend alle Gruppen des zweiten Typs abgenommen werden.

4. Verfahren nach einem der Ansprüche 1 bis 3, dadurch gekennzeichnet, daß jede Gruppe von Abtastproben einen einzigen Abtastwert jeder elektrischen Größe enthält, die für die Berechnung der zu messenden Leistung bzw. Leistungen erforderlich ist.

5. Verfahren nach einem der Ansprüche 1 bis 4, zur Messung der elektrischen Wirkleistung und Blindleistung an einem einphasigen Wechselstromnetz oder abgeglichenen Dreiphasen-Wechselstromnetz, dadurch gekennzeichnet, daß jede Gruppe von Abtastproben einen Abtastwert für die Stromstärke zwischen einem Abtastwert der einfachen Spannung und einem Abtastwert der Spannung zwischen den Phasen umfaßt, oder umgekehrt.

6. Verfahren nach einem der Ansprüche 1 bis 4, zur Messung der elektrischen Wirkleistung und Blindleistung an einem einphasigen oder abgeglichenen dreiphasigen Wechselstromnetz, dadurch gekennzeichnet, daß wenigstens eine Menge von Abtastproben abgenommen wird, die aus zwei k Gruppen besteht, welche nacheinander und regelmäßig über eine Halbperiode des Netzes abgenommen werden und jeweils ein Spannungs- und Stromstärken-Abtastwertepaar enthalten worin k ganzzahlig ist; daß unter den Wirk- und Blindleistungen diejenige, welche der Art der abgetasteten Größen entspricht, aus der Kumulierung der zwei zu zwei gebildeten Produkte der Abtastwerte jeder Gruppe berechnet wird; und daß die andere Leistung berechnet wird aus der Kumulierung der zwei zu zwei gebildeten Produkte der Stromstärken- oder Spannungs-Abtastwerte einer Gruppe mit den Spannungs- oder Stromstärken-Abtastwerten der—von dieser Gruppe ausgerechnet—k-ten Gruppe.

7. Verfahren nach einem der Ansprüche 1 bis 4, zur Messung der elektrischen Leistungen an einem Mehrphasen-Wechselstromnetz, dadurch gekennzeichnet, daß jede Gruppe von Abtastproben für jede Phase eine Untergruppe enthält, die in der angegebenen oder der entgegengesetzten Reihenfolge einen Stromstärken-Abtastwert der Phase und wenigstens einen Spannungs-Abtastwert enthält; wobei die Reihenfolge der Phasen in den Gruppen des ersten Typs unveränderlich und umgekehrt zur Reihenfolge der Phasen in den Gruppen des zweiten Typs ist.

8. Verfahren nach einem der Ansprüche 1 bis 4, zur Messung der elektrischen Wirkleistung und Blindleistung an einem dreiphasigen Wechselstromnetz, dadurch gekennzeichnet, daß Gruppen abgenommen werden, welche wenigstens zwei Paare von Abtastwerten enthalten, die jeweils gebildet sind aus einem Spannungs-Abtastwert und einem Stromstärken-Abtastwert, welcher die Differenz zwischen den Stromstärken von zwei Phasen des Netzes darstellt.

9. Verfahren nach einem der vorstehenden Ansprüche, dadurch gekennzeichnet, daß regelmäßig 16 Gruppen von Abtastproben währen einer Netzperiode abgenommen werden.

10. Verfahren nach einem der vorstehenden Ansprüche, dadurch gekennzeichnet, daß der Übergang einer ausgewählten Größe unter den abgetasteten elektrischen Größen in einen ersten bestimmten Zustand erfaßt wird, daß die regelmäßige Abnahme von Gruppen von Abtastproben ansprechend auf diese Erfassung ausgelöst wird, daß der Übergang dieser selben elektrischen Größe in einen zweiten Zustand erfaßt wird, dessen Phasenlage entgegengesetzt zu derjenigen des ersten Zustands ist, und daß die regelmäßige Abnahme einer selben Anzahl von Abtastgruppen ansprechend auf diese zweite Erfassung ausgelöst wird.

11. Verfahren nach Anspruch 10, dadurch gekennzeichnet, daß der Nulldurchgang der genannten gewählten Größe nacheinander in dem einen und in dem anderen Sinn erfaßt wird.

12. Verfahren nach einem der vorstehenden Ansprüche, dadurch gekennzeichnet, daß aus den über eine Dauer, die gleich einer Netzperiode oder gleich einem Vielfachen derselben ist, abgenommenen Abtastproben einer elektrischen Größe der Mittelwert gebildet wird, um für die Abtastproben dieser Größe einen Null-Bezugswert zu liefern.

13. Verfahren nach einem der Ansprüche 1 bis 12, dadurch gekennzeichnet, daß regelmäßig Gruppen von Abtastproben über eine Dauer abgenommen werden, die gleich der Netzperiode oder einem Vielfachen derselben ist, wobei jede Gruppe wenigstens ein Abtastwertepaar für die Spannung und die Stromstärke enthält, daß jede erhaltene elementaire Lestung $Pi$ berechnet wird, indem die Abtastwerte jedes dieser Paare zu zweit multipliziert werden, daß der Mittelwert $M_v$ der Spannungs-Abtastwerte dieser Paare berechnet wird, der Mittelwert $M_l$ der Stromstärken-Abtastwerte der genannten Paare berechnet wird und die Größe

$$\sum_1^N Pi - N \cdot M_v \cdot M_l$$

berechnet wird, worin N die Anzahl von Gruppen von abgenommenen Abtastproben und

$$\sum_{1}^{N} Pi$$

die Summe der N berechneten Elementarleistungen ist.

14. Gerät zur Messung der elektrischen Leistung an einem Wechselstromnetz, mit einer digitalen Rechenvorrichtung zur Leistungsberechnung (OC; OC') einer Umsetzvorrichtung (CAN; CAN'), welche der Rechenvorrichtung über einen einzigen Kanal Digitalinformationen liefert, die Abtastproben entsprechen, welche zu unterschiedlichen Zeitpunkten abgenommen wurden und elektrische Größen des Netzes darstellen, die die zu messende Leistung bzw. zu messenden Leistungen betreffen, mit einer Schaltvorrichtung (MX; MX'), welche den Eingang der Umsetzvorrichtung mit Meßwertaufnehmern (TV1, Ti1, TU23, TV2, Ti2, TU31, TV3, Ti3, TU12; TV1, TI21, TU23, TV3, TI23, TU12) zur Abnahme der elektrischen Größen verbindet, und mit einem Speicher (RD; RD') zur Aufzeichnung der Abtastproben, die während einer Abnahmedauer abgenommen und durch den Umsetzer (CAN; CAN') umgesetzt wurden, dadurch gekennzeichnet, daß

— die Schaltvorrichtung (MX, MX') die Umsetzvorrichtung mit den Meßwertaufnehmern verbindet, um regelmäßig über eine Dauer, die im wesentlichen gleich einer Halbperiode des Netzes oder einem Vielfachen derselben ist, Gruppen von Abtastproben abzunehmen, die aus Gruppen eines ersten Typs bestehen, welche jeweils wenigstens ein Abtastprobenpaar für Spannung und Stromstärke enthalten, die eine gewünschte Leistung betreffen und in einer bestimmten Reihenfolge sowie mit einem bestimmten Zeitintervall abgenommen, werden, und Gruppen eines zweiten Typs abzunehmen, deren Anzahl gleich derjenigen der Gruppen des ersten Typs ist und die jeweils wenigstens ein Abtastprobenpaar für dieselbe Spannung und dieselbe Stromstärke wie bei den Paaren der Gruppen des ersten Typs enthalten und mit demselben Zeitintervall, jedoch in einer zu der bestimmten Reihenfolge entgegengesetzten Reihenfolge abgenommen werden, wobei alle Gruppen der beiden Typen gebildet sind aus Abtastproben, die alle zu voneinander verschiedenen Zeitpunkten abgenommen wurden, wobei die Gruppen des ersten Typs eine zeitliche Verteilung aufweisen, die symmetrisch zu der Verteilung der Abnahmezeitpunkte der Gruppen des zweiten Typs in bezug auf die Mitte der Abnahmedauer ist, und daß

— die Rechenvorrichtung Mittel zum Rechnen und Kumulieren der Elementarleistungen enthält, die erhalten werden, indem die Abtastwerte der Paare in den verschiedenen Gruppen zu zweit miteinander multipliziert werden.

15. Gerät nach Anspruch 14, dadurch gekennzeichnet, daß die Schaltvorrichtung (MX) die Umsetzvorrichtung (CAN) nacheinander mit den verschiedenen Meßwertaufnehmern (TV1, TI1,...) in einer vorbestimmten Reihenfolge und dann mit denselben Meßwertaufnehmern in der entgegengesetzten Reihenfolge usw. verbindet.

16. Gerät nach Anspruch 14 oder 15, dadurch gekennzeichnet, daß die Schaltvorrichtung (MX) die Umsetzvorrichtung (CAN) mehrfach nacheinander mit verschiedenen Meßwertaufnehmern (TV1, TI1,...) in einer bestimmten Reihenfolge verbindet, um die Gruppen des ersten Typs abzunehmen, und anschließend ebenso oft mit diesen selben Meßwertaufnehmern in der umgekehrten Reihenfolge verbindet, um die Gruppen des zweiten Typs abzunehmen.

17. Gerät nach einem der Ansprüche 14 bis 16 zum Messen der Wirkleistung und der Blindleistung eines Dreiphasen-Wechselstromnetzes, dadurch gekennzeichnet, daß für jede Abnahme einer Gruppe von Abtastproben einer oder jeder Phase die Schaltvorrichtung (MX) den Umsetzer (CAN) nacheinander verbindet mit einem Meßwertaufnahmer (TV1, TV2, TV3) für die Phasenspannung, einem Meßwertaufnehmer (TI1, TI2, TI3) für die Phasenstromstärke und einem Meßwertaufnahmer (TU23, TU31, TU12) für die Spannung zwischen den Phasen, und zwar in der genannten Reihenfolge oder in der umgekehrten Reihenfolge.

18. Gerät nach einem der Ansprüche 14 bis 17, zur Messung der Wirkleistung und der Blindleistung eines Wechselstromnetzes, dadurch gekennzeichnet, daß der Speicher (RD) zum Speichern einer Menge von Abtastproben bestimmt ist, die aus zwei k Gruppen besteht, welche nacheinander und regelmäßig über eine Halbperiode des Netzes abgenommen werden und jeweils ein Abtastprobenpaar für die Spannung und die Stromstärke enthalten, worin k eine ganze Zahl ist, und die Rechenvorrichtung (OC) Mittel zum Berechnen und Kumulieren der Elementarleistungen enthält, die erhalten werden, indem die Abtastwerte jedes Paares zwei zu zwei multipliziert werden, sowie Mittel zum Berechnen und Kumulieren der Elementarleistungen enthält, die erhalten werden, indem der Strom—oder Spannungs-Abtastwert einer Gruppe mit dem Spannungs—oder Stromstärken-Abtastwert der—von dieser Gruppe ausgehend berechnet—k-ten Gruppe zwei zu zwei multipliziert werden.

19. Gerät nach einem der Ansprüche 14 bis 18, zur Messung der Wirkleistung und/oder Blindleistung in einem Dreiphasen-Wechselstromnetz, dadurch gekennzeichnet, daß es wenigstens zwei Stromstärken-Meßwertaufnehmer umfaßt, die jeweils ein Signal (I21, I23) abgeben, welches die Differenz zwischen den Stromstärken der beiden Phasen darstellt.

14

20. Gerät nach einem der Ansprüche 14 bis 19, dadurch gekennzeichnet, daß die Abnahmefrequenz für die Gruppen von Abtastproben gleich dem n.16-fachen der Frequenz des Netzes ist, worin n eine ganze Zahl ist.

21. Gerät nach einem der Ansprüche 14 bis 20, dadurch gekennzeichnet, daß es Detektionsmittel (OC) zur Erfassung des Übergangs einer aus den elektrischen Größen ausgewählten Größe in einen bestimmten Zustand umfaßt, um die Abnahme einer bestimmten Anzahl von Gruppen von Abtastproben während einer Dauer auszulösen, die der Dauer einer normalen Halbperiode des Netzes entspricht.

22. Gerät nach Anspruch 21, dadurch gekennzeichnet, daß die Detektionsmittel (OC) eine Detektionsvorrichtung zur Erfassung des Nulldurchgangs der gewählten elektrischen Größe in dem einen oder im anderen Sinne umfaßt.

23. Gerät nach einem der Ansprüche 14 bis 23, dadurch gekennzeichnet, daß die Rechenvorrichtung Mittel zur Berechnung des Mittelwerts der Abtastproben wenigstens einer der abgetasteten elektrischen Größen enthält.

**Claims**

1. A method for measuring the electrical power on an alternative current network, wherein samples taken at different time points and representative of the various network electrical magnitudes related to the power or to each power to be measured are transmitted to a computing device through a single channel, characterized:

— in that, over a determined time period which is equal to or a multiple of the network half-period, sample groups are respectively taken which comprise groups of a first kind each including at least one couple formed by voltage and current samples related to a desired power and taken in a determined order and with a determined time interval, and groups of a second kind in the same number as the groups of the first kind and each including at least one couple of samples of the same voltage and current as said couples in the groups of the first kind, taken with the same time interval but in a reverse order to said determined order, each group of both kinds comprising samples which are all taken at different times, the distribution of the sampling times of the first kind groups and the distribution of the sampling times of the second kind groups being symmetrical to one another relative to the middle of the sampling period and,

— in that the individual powers obtained by multiplying with one another the samples from the couples of the various groups are cumulated.

2. A method according to claim 1, wherein a group of the first kind and a group of the second kind are alternately sampled.

3. A method according to claim 1, wherein all the groups of the first kind and then all the groups of the second kind are sequentially sampled.

4. A method according to any claim 1 to 3, wherein each group of samples comprises a single sample of each electrical magnitude required for calculating the power(s) to be measured.

5. A method according to any claim 1 to 4 for the active and reactive measurement of electrical powers on a single or three-phase balanced alternating current network, wherein either each sample group comprises a current intensity sample between a simple voltage sample and a composed voltage sample, or conversely.

6. A method according to any of claims 1 to 4 for the active and reactive measurement of electrical power on a single or three-phase balanced alternating current network, wherein at least one set of samples is taken which comprises 2 k groups consecutively and regularly sampled over one network half-period and each including a couple of voltage and current samples, k being an integer number; wherein that of the active and reactive powers which corresponds to the nature of the magnitudes sampled is calculated from the cumulative two-by-two products of the samples from each group; and wherein the other power is calculated from the cumulated two-by-two products of the current—or voltage—sample of one group with the voltage—or current—sample of the kth group counted from this group.

7. A method according to any of claims 1 to 4, for measuring electrical powers on a multi-phase alternating current network, wherein each sample group comprise, for each phase, a sub-group comprising a phase current intensity sample and at least one voltage sample in this or the reverse order; the order of the phases within the groups of the first kind being invariable and the reverse of the order of phases within the groups of the second kind.

8. A method according to any of claims 1 to 4, for the active and reactive measurement of electrical powers on a three-phase alternating current network, wherein groups are taken which comprise at least two couples of samples each formed of a voltage sample and a current sample representative of the difference between the current intensities of both phases of the network.

9. A method according to any of the previous claims, wherein 16 sample groups are regularly taken over one network period.

10. A method according to any of the previous claims, wherein the occurrence of one electrical magnitude which has been selected and sampled in a first determined state is detected, wherein the regular sampling of sample groups is triggered in response to this detection, wherein the occurrence of the same electrical magnitude is detected in a second state in phase-opposition to the first one, and wherein the regular sampling of an equal number of sample groups is triggered in response to this second detection.

11. A method according to claim 10, wherein the zero crossing of said selected magnitude is detected alternately in one direction and in the opposite one.

12. A method according to any of the previous claims, wherein the mean value of the samples of one electrical magnitude which are taken over a time lapse equal to or multiple of the network period is computed, in order to provide a zero reference for the samples of this magnitude.

13. A method according to any of claims 1 to 12, wherein sample groups are regularly taken over a time lapse which is equal to or a multiple of the network period, each group comprising at least a couple of voltage and current samples, wherein each individual power Pi obtained by multiplying with one another the samples of each said couples is computed, wherein the mean value $M_v$ of the voltage samples in said couples is computed, wherein the mean value $M_i$ of the current samples in said couples is computed and wherein the quantity:

$$\sum_{1}^{N} P_i - N \cdot M_v \cdot M_i,$$

is computed, where N is the number of sample groups taken and

$$\sum_{1}^{N} P_i$$

is the sum of the N individual computed powers.

14. An apparatus for measuring the electrical power on an alternating current network, comprising a digital power computing device (OC; OC'), a converter device (CAN; CAN') providing the computing device through a single channel with digital information corresponding to samples taken at various times and representative of the electrical magnitudes of the network which are related to the power or to each power to be measured, a switching device (MX; MX') which connects the input of the converter device to sensors (TV1, Ti1, TU23, TV2, Ti2, TU31, TV3, Ti3, TU12; TV1, Ti21, TU23, TV3, Ti23, TU12) for said electrical magnitudes, and a memory (RD; RD') for recording the samples taken during a sampling period and converted by the converter (CAN; CAN'), wherein the switching device (MX, MX') connects the converter device to sensors for regularly sampling, over a time interval which is substantially equal to or a multiple of the network half-period, sample groups comprising groups of a first kind each including at least one couple of voltage and current samples related to a desired power and taken in a given order with a given time interval, and groups of a second kind in the same number as the groups of the first kind and each including at least one couple of samples of the same voltage and current as for said couples from the groups of the first kind, taken with the same interval but in a reverse order to said given order, each group of both kinds comprising samples which are all taken at different times, and the groups of the first kind having a time distribution which is symmetrical to the distribution of the sampling times of the groups of the second kind relative to the middle of the sampling period and wherein the computer device comprises means for calculating and cumulating the individual powers obtained by multiplying with one another the samples in said couples from different groups.

15. An apparatus according to claim 14, wherein the switching device (MX) sequentially connects the converter device (CAN) to various sensors (TV1, TI1,...) in a predetermined order and then to the same sensors in the opposite order, and so on.

16. An apparatus according to any of claims 14 and 15, wherein the switching device (MX) sequentially connects several times the converter device (CAN) to various sensors (TV1, Ti1,...) in a determined order to sample the groups of the first kind and thereafter, a same number of times, to the same sensors in the reverse order to sample the groups of the second kind.

17. An apparatus according to claims 14 to 16 for measuring the active and reactive power of a three-phase alternating current network, wherein, for each sampling of a sample group for one or each phase, the switching device (MX) sequentially connects the converter (CAN) to a simple voltage sensor (TV1, TV2, TV3) to a phase current intensity sensor (Ti1, Ti2, Ti3) and to a composed voltage sensor (TU23, TU31, TU12) in this or the reverse order.

18. An apparatus according to any of claims 14 to 17, for measuring the active or reactive powers of an alternating current network, wherein the memory (RD) is intended to record a set of samples comprising 2 k groups sequentially and regularly taken over one half-period of the network, and each including a couple of voltage and current samples, k being an integer number, and wherein the computing device (OC) comprises means for computing and cumulating the individual powers obtained by multiplying two-by-two the samples of each couple and means for computing and cumulating the individual powers obtained by multiplying two-by-two the current—or voltage—network of one group with the voltage—or current—sample of the $k^{th}$ group counted from this group.

19. An apparatus according to any of claims 14 to 18, for measuring the active and/or reactive power of a three-phase alternating current network, wherein said apparatus comprises at least two current sensors, each delivering a signal (I21, I23) representative of the difference between the currents of both phases.

20. An apparatus according to any of claims 11 to 19, wherein the sampling frequency of the sample groups is equal to n.16 times the network frequency, where n is an integer number.

21. An apparatus according to any of claims 14 to 20 wherein it comprises means for detecting (OC) the occurrence of a magnitude selected among said electrical magnitudes in a determined state, for triggering the sampling of a determined number of sample groups during a time interval corresponding to that of a normal half-period of the network.

22. An apparatus according to claim 21, wherein said detector means (OC) comprise a device for detecting the zero crossing of the selected electrical magnitude, in one direction or the other.

23. An apparatus according to any of claim 14 to 22, wherein the computer device comprises means for computing the mean value of the samples of at least one of the sampled electrical magnitudes.

Fig. 1

Fig. 4

1

Fig. 2

**Fig. 3**

début

A = 1

[C] = 16

VI = 0? — NON

OUI

A = 1? — NON / OUI

C = 16? ou 8 — OUI

NON

temporisation To/16_3ΔT

temporisation To/16_ΔT

prélèvement V1*

prélèvement I1*

prélèvement I1*

prélèvement V1*

stockage V1*I1*

stockage I1* V1*

A = 1

A = 0

[C] = [C] _ 1

[C] = 8 — OUI

NON

[C] = 0 — NON

OUI

calcul $P = K'_p \sum V1_i \, I1_i$   $Q = K'_q \sum V1_j \, I1_i$

calcul $M_v = \frac{1}{10} \sum V1_i$   $M_I = \frac{1}{10} \sum I1_i$

calcul $P' = P - 16 \, M_V \, M_I$   $Q' = Q - 16 \, M_V \, M_I$

calcul $V_{eff} = K_V \sum / V1_i^*$ / $I_{eff} = K_I \sqrt{\dfrac{P'^2 + Q'^2}{V1^2_{eff}}}$

calcul $tg\varphi = \dfrac{Q'}{P'}$

fin

3